# EUROPEAN PATENT APPLICATION

(11) **EP 4 561 281 A1**
(43) Date of publication of application: **28.05.2025**
(21) Application number: 23915718.3
(22) Date of filing: 21.11.2023
(51) Int. Cl.: H05K 7/20, B32B 9/00

(54) **GRAPHENE SHEET, PREPARATION METHOD, HEAT DISSIPATION MODULE, AND ELECTRONIC DEVICE**

(30) Priority: 13.01.2023 CN 202310078605
(71) Applicant: Huawei Technologies Co., Ltd., Shenzhen, Guangdong 518129 (CN)
(72) Inventor: ZHANG, Zhou, Shenzhen, Guangdong 518129 (CN); LIU, Jiaju, Shenzhen, Guangdong 518129 (CN); BAI, Lei, Shenzhen, Guangdong 518129 (CN); WU, Chenglin, Shenzhen, Guangdong 518129 (CN); TU, Yiming, Shenzhen, Guangdong 518129 (CN); JIN, Linfang, Shenzhen, Guangdong 518129 (CN)
(74) Representative: MERH-IP Matias Erny Reichl Hoffmann Patentanwälte PartG mbB
(86) International application number: PCT/CN2023/132979
(87) International publication number: WO 2024/148960

(57) **Abstract**

This application provides a graphene sheet, a preparation method, a heat dissipation module, and an electronic device, and pertains to the field of heat dissipation technologies for electronic devices. The graphene sheet includes: a substrate layer, where the substrate layer includes a plurality of graphene layers disposed in a thickness direction of the substrate layer, at least one hole is provided in a preset region of the substrate layer, the at least one hole extends in the thickness direction of the substrate layer from a first surface to a second surface opposite to the first surface, and an extension distance of the hole is less than or equal to a thickness; and a metal layer, where the metal layer is disposed on the first surface, metal pillars of the metal layer extend through a plurality of holes toward the second surface of the substrate layer, and at least a part of a periphery of the metal pillar is in contact with a side wall of the hole. The graphene sheet in this application has a light weight and good heat conduction performance, and graphene layers are fastened under the action of mechanical bonding and chemical bonding, so that a delamination problem of the graphene sheet caused by thermal stress is avoided.

## Description

This application claims priority to Chinese Patent Application No. 202310078605.1, filed with the China National Intellectual Property Administration on January 13, 2023 and entitled "GRAPHENE SHEET, PREPARATION METHOD, HEAT DISSIPATION MODULE, AND ELECTRONIC DEVICE", which is incorporated herein by reference in its entirety.

### TECHNICAL FIELD

This application relates to the field of heat dissipation technologies, and in particular, to a graphene sheet, a preparation method, a heat dissipation module, and an electronic device.

### BACKGROUND

A graphene heat dissipation film is a flexible thermally conductive material with a thermal conductivity exceeding 1000 W/(K.m) on a horizontal plane, and can quickly conduct heat in a horizontal direction. Therefore, the graphene heat dissipation film has been widely used in structures such as a heat dissipation module of a mobile phone and a heat spreader of a tablet computer. As power of central processing units (Central Processing Unit, CPU) of some electronic devices increases and a thinning requirement for an entire device rises, there is an increasingly strong requirement for developing a heat dissipation module with a small size and high heat conduction performance, for example, a vapor chamber (Vapor Chamber, VC), which is also referred to as a planar heat pipe. However, the VC is costly and heavy. A density of copper alloys in the VC is about 8.9 g/cm³. However, in a current product, a heat dissipation material that has both good heat conduction performance and a light weight is more urgently needed.

A density of a graphene sheet is 1.8 g/cm³, and can meet a requirement for a light weight and low costs. However, heat conduction of graphene depends on conduction, and a thermally conductive coefficient of the graphene is still lower than that of the VC that conducts heat through a phase change. Therefore, in actual application, the graphene needs to be used in combination with a copper VC, a heat pipe, or another metal structure with a high thermal conductivity. This relates to a connection between the graphene sheet and the metal structure. Therefore, to facilitate connection effect of interfaces of the foregoing different types of materials, metallization needs to be performed on a surface of the graphene. Usually, a common graphene metallization technology is a magnetron sputtering (Physical Vapor Deposition, PVD) technology. However, in the technology, a metal atom is mainly combined with a graphene surface layer through a physical adsorption action, and the metal layer and the graphene are prone to delamination due to a low combination force, resulting in inapplicability to a mechanical part that needs to withstand vibration and a drop force.

### SUMMARY

In view of this, this application provides a graphene sheet, a preparation method, a heat dissipation module, and an electronic device, to resolve a problem that a graphene material is prone to delamination in a metallization process and therefore is not applicable to a mechanical part that needs to withstand vibration and a drop force.

Some implementations of this application provide a graphene sheet. The following describes this application from a plurality of aspects. Mutual reference may be made to implementations and beneficial effects of the following plurality of aspects.

According to a first aspect, this application provides a graphene sheet, including:
a substrate layer, where the substrate layer includes a plurality of graphene layers disposed in a thickness direction of the substrate layer, at least one hole is provided in a preset region of the substrate layer, the at least one hole extends in the thickness direction of the substrate layer from a first surface to a second surface opposite to the first surface, and an extension distance of the hole is less than or equal to the thickness; and
a metal layer, where the metal layer is disposed on the first surface, metal pillars of the metal layer extend through a plurality of holes toward the second surface of the substrate layer, a length of the metal pillar is less than or equal to a length of the hole, and at least a part of a periphery of the metal pillar is in contact with a side wall of the hole.

According to the graphene sheet in this embodiment of this application, the hole is provided in the substrate layer, the metal pillar is formed in the hole, the metal pillar and the hole achieve "pinning" effect, and the graphene layers are fastened under the action of mechanical binding, physical binding, and chemical bonding, so that a delamination problem of the graphene sheet caused by thermal stress is avoided.

In an embodiment of the first aspect of this application, there are a plurality of holes, and extension lengths of the plurality of holes are not equal. Solidness of different graphene layers is protected by using different hole lengths.

In an embodiment of the first aspect of this application, an extension length of a hole close to an edge of the substrate layer is greater than an extension length of a hole away from the edge of the substrate layer. Such a structure better helps protect graphene at the edge from being delaminated.

In an embodiment of the first aspect of this application, a chemical bond is formed between the metal pillar in the hole and the hole wall. The chemical bond can fasten the graphene layers to the metal pillar, so that delamination of the graphene layers is effectively avoided.

In an embodiment of the first aspect of this application, a density of a quantity of holes arranged in the preset region is greater than 0.01/mm². According to such a density, the graphene layers can be effectively fastened, and it can be avoided that too many graphene holes affect overall integrity and thermal conductivity of graphene.

In an embodiment of the first aspect of this application, the plurality of holes are arranged in a horizontal direction and a vertical direction of the substrate layer.

In an embodiment of the first aspect of this application, horizontally arranged holes and vertically arranged holes are aligned or staggered. An orderly arrangement manner helps the graphene layers bear a uniform force and avoid delamination.

In an embodiment of the first aspect of this application, the thickness of the substrate layer is less than or equal to 2 mm, and a distance between two points that are farthest from each other on a cross section of the hole is less than 5 mm. After the metal pillar is formed, such a size can not only fasten the graphene layer, but also avoid that an excessively large hole affects heat conduction performance of the graphene, or increases an overall weight of the graphene sheet.

In an embodiment of the first aspect of this application, a distance between the hole and an outer edge of the substrate layer is less than or equal to 5 mm. Such a distance helps protect the graphene layers at the edge from being delaminated.

In an embodiment of the first aspect of this application, both the metal layer and the metal pillar are brazing filler metal including a titanium element, and a Ti-C chemical bond is formed between the metal pillar and the hole wall. The chemical bond helps fasten each layer and avoid delamination.

In an embodiment of the first aspect of this application, a percentage of a quantity of atoms of titanium in a total quantity of atoms of the brazing filler metal is less than or equal to 15%.

In an embodiment of the first aspect of this application, the brazing filler metal further includes one or more elements of copper, silver, tin, and nickel.

In an embodiment of the first aspect of this application, the first surface of the preset region of the substrate layer is divided into a metal region and a non-metal region, one non-metal region is provided between every two adjacent metal regions, and the metal layer is disposed in the metal region. Such a structure helps reduce inner stress generated in a metallization process, improve overall deformation of the graphene, improve hole forming efficiency, and reduce an increased weight and costs of the brazing filler metal.

In an embodiment of the first aspect of this application, a plurality of metal regions are arranged in a row in the horizontal direction of the substrate layer; or a plurality of metal regions are arranged in a column along the plurality of metal regions; or a plurality of metal regions are arranged in n rows in the horizontal direction of the substrate layer and in m columns in the vertical direction, where n and m are natural numbers greater than 1. Such a structure better helps the graphene layers achieve uniform pinning effect.

In an embodiment of the first aspect of this application, the hole is provided in the metal region. This helps achieve pinning effect.

In an embodiment of the first aspect of this application, the plurality of holes are arranged in a horizontal direction and a vertical direction of the metal region in an aligned or staggered manner.

In an embodiment of the first aspect of this application, the hole is a through hole or a blind hole.

In an embodiment of the first aspect of this application, the cross section of the hole is a circle, a triangle, or a square.

According to a second aspect, this application further discloses a preparation method for a graphene sheet. The graphene sheet includes a substrate layer, the substrate layer includes a plurality of graphene layers disposed in a thickness direction of the substrate layer, and the method includes:
forming at least one hole in a preset region of the substrate layer, where the at least one hole extends in the thickness direction of the substrate layer from a first surface to a second surface opposite to the first surface, and an extension distance of the hole is less than or equal to the thickness;
covering the first surface of the preset region with brazing filler metal, to obtain a prefabricated material part; and
placing the prefabricated material part in a high-temperature vacuum furnace for heating, to melt the brazing filler metal, so that a part of the melted brazing filler metal flows into the hole, and the graphene sheet is obtained after the melted brazing filler metal cools down.

According to the preparation method for a graphene sheet in this embodiment of this application, a micropore structure is designed in the graphene sheet before high-temperature metallization. After infiltration of the brazing filler metal, the structure can change a direction of thermal stress generated by a metal layer and graphene due to a thermal expansion coefficient, and the brazing filler metal and an inner side wall of the hole form a chemical bond and physical bonding effect, to resist an exfoliation force of the graphene layer in a metallization process, and resolve a problem of surface delamination after high-temperature metallization of graphene.

**In** an embodiment of the second aspect of this application, there are a plurality of holes, and extension lengths of the plurality of holes are not equal.

**In** an embodiment of the second aspect of this application, the forming at least one hole in a preset region of the substrate layer includes:
arranging the holes in a horizontal direction and a vertical direction of the preset region in an aligned or staggered arrangement manner, or arranging the holes in an obliquely aligned manner.

**In** an embodiment of the second aspect of this application, the first surface of the preset region includes a metal region and a non-metal region, and the forming at least one hole in a preset region of the substrate layer includes:
dividing the preset region into the metal region and the non-metal region, where the metal region and the non-metal region are spaced apart; and
forming at least one hole in the metal region of the preset region; and
the covering the first surface of the preset region with brazing filler metal includes:
   covering the metal region with the brazing filler metal.

In an embodiment of the second aspect of this application, a thickness of the brazing filler metal covering the surface of the preset region is less than or equal to 2.0 mm.

In an embodiment of the second aspect of this application, the brazing filler metal includes at least a titanium element.

In an embodiment of the second aspect of this application, a percentage of a quantity of atoms of titanium in a total quantity of atoms of the brazing filler metal is less than or equal to 15%.

In an embodiment of the second aspect of this application, a heating temperature is greater than 600°C.

According to a third aspect, this application further discloses a heat dissipation module, including:
a heat dissipation part, where the heat dissipation part includes a metal housing and a liquid medium located in the metal housing; and
a graphene sheet, where a metal layer on a surface of the graphene sheet is connected to the housing of the heat dissipation part, and the graphene sheet is the graphene sheet according to the embodiment of the first aspect.

The heat dissipation module according to this embodiment of this application has relatively good heat dissipation effect, a light weight, and low costs.

In an embodiment of the third aspect of this application, the heat dissipation part is a heat pipe.

According to a fourth aspect, this application further discloses an electronic device, including the heat dissipation module according to the embodiment of the third aspect.

According to a fifth aspect, this application further discloses an electronic device, including the graphene sheet according to the embodiment of the first aspect.

### BRIEF DESCRIPTION OF DRAWINGS

FIG. 1 is a diagram of composition of a microstructure of a graphene material;
FIG. 2 is a diagram of a macrostructure of delamination of a graphene sheet;
FIG. 3 is a real diagram of delamination of a graphene sheet;
FIG. 4a is a top view of a graphene sheet according to an embodiment of this application;
FIG. 4b is a cross-sectional view in the A-A direction in FIG. 4a;
FIG. 5 is a diagram of an arrangement structure of holes on a surface of graphene observed from a top-view perspective according to an embodiment of this application;
FIG. 6 is a diagram of a structure of a hole in a graphene sheet according to an embodiment of this application;
FIG. 7 is a diagram of a hybrid structure of a blind hole and a through hole in a graphene sheet according to an embodiment of this application;
FIG. 8 is a flowchart of a preparation method for a graphene sheet according to an embodiment of this application;
FIG. 9 is a diagram of a structure in a graphene preparation process according to an embodiment of this application;
FIG. 10 is a diagram of a structure of a graphene sheet divided into regions in different directions of a substrate layer according to an embodiment of this application;
FIG. 11 is a diagram of a structure of arranging a hole in a metal region of a substrate layer according to an embodiment of this application;
FIG. 12 is a flowchart of a preparation method for a graphene sheet according to another embodiment of this application;
FIG. 13a is a diagram of a simulation test of a warping degree of a graphene sheet that is not divided into regions according to an embodiment of this application;
FIG. 13b is a diagram of a simulation test of a warping degree of a graphene sheet that is divided into regions according to an embodiment of this application; and
FIG. 14 is a diagram of a structure of a heat dissipation module according to an embodiment of this application.

### DESCRIPTION OF EMBODIMENTS

The following clearly and completely describes embodiments of this application with reference to the accompanying drawings.

For ease of understanding the technical solutions of this application, the following first describes the technical problem in this application.

An existing heat dissipation part usually uses a vapor chamber VC. The VC is made of two materials. A metal housing is used on the periphery of the VC, and a heat-conducting medium is borne in the housing. The medium has good fluidity, to facilitate heat dissipation of a heat-generating product, for example, heat dissipation of a CPU. Because the metal housing in the VC is made of a copper alloy material with a density of about 8.9 g/cm³, the VC prepared by using the copper alloy material is costly and heavy. For an electronic product with a high requirement for weight and cost control, a material with a light weight, good heat conduction performance, and low costs is more needed. A graphene material has characteristics of good heat conduction performance and a light weight, and can meet a disadvantage of the VC.

However, the graphene material depends on conduction to perform heat conduction. To improve heat conduction performance of graphene, in actual application, the graphene needs to be used in combination with a copper VC, a heat pipe, or another metal piece with a high thermal conductivity. For example, a graphene sheet and a heat dissipation part, such as a dense-tooth heat dissipation part or a fin, are welded together with a heat pipe. Because the graphene is a non-metallic material, when the graphene is welded to another metal piece, a connection is unstable. To facilitate connection effect of interfaces of the foregoing different types of materials, metallization needs to be performed on a surface of the graphene material.

The following describes a problem that is prone to occur in a metallization process of the graphene material.

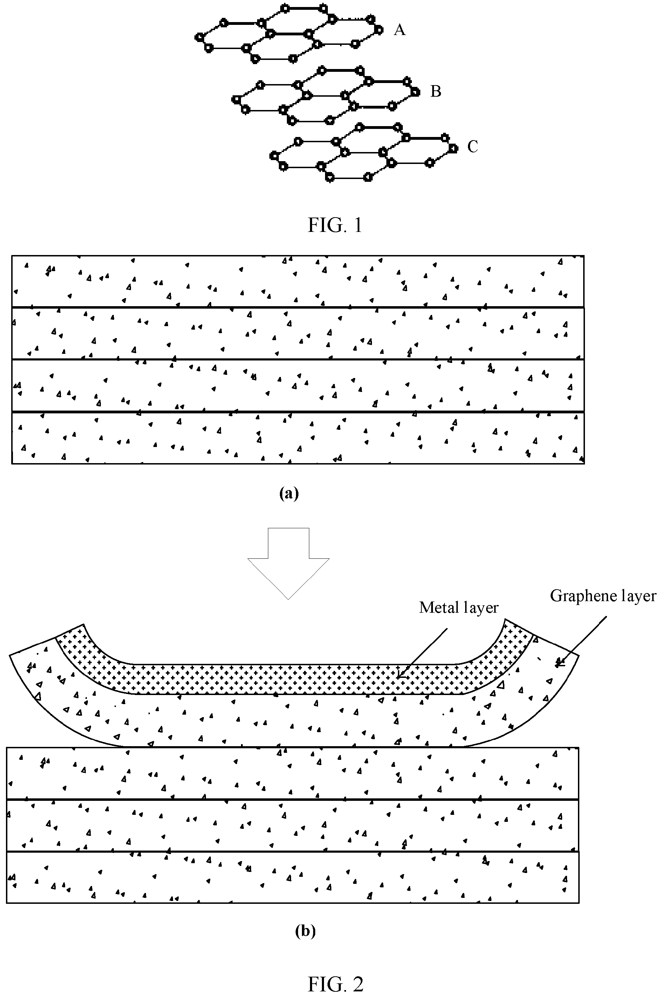

Refer to FIG. 1. FIG. 1 is a diagram of composition of a microstructure of a graphene material. The graphene material includes a plurality of graphene layers, and has a specific thickness. The graphene layers are connected to each other by using a van der Waals force. As shown in FIG. 1, each graphene layer corresponds to at least one carbon atom layer, and a structure of the carbon atom layer is shown by a layer A, a layer B, and a layer C in FIG. 1. There is no chemical bond formed between these layers, and a van der Waals force between the layers is small. In a metallization process of the graphene material, a surface of a region that is of the graphene material and that needs to be metallized is first covered with brazing filler metal, and then the graphene material is placed in a high temperature furnace for heating, so that the brazing filler metal is melted. After a solution of the brazing filler metal fully reacts with a surface layer of the graphene material, cooling is performed to reduce a temperature, and the metallization process is completed. In this process, a thermal expansion coefficient of a metal layer is more than 10 times that of a surface of each layer of the graphene material. Therefore, in a cooling process, relatively large thermal residual stress is generated between the metal layer and the graphene surface layer. When the residual stress is greater than the van der Waals force between the graphene layers, exfoliation of the graphene surface layer or even more layers is caused, a structure of the graphene sheet is damaged, and heat conduction performance is affected.

Refer to FIG. 2. FIG. 2 is a diagram of a macrostructure of a graphene sheet changing from non-delaminated to delaminated and stacked. (a) in FIG. 2 shows a structure of the graphene sheet observed from a macro perspective when the graphene sheet is not delaminated. In a metallization process, relatively large thermal residual stress is generated between a metal layer and a graphene surface layer, so that a first graphene layer and a second graphene layer are delaminated. As shown in (b) in FIG. 2, the first graphene layer and the second graphene layer are separated (delaminated).

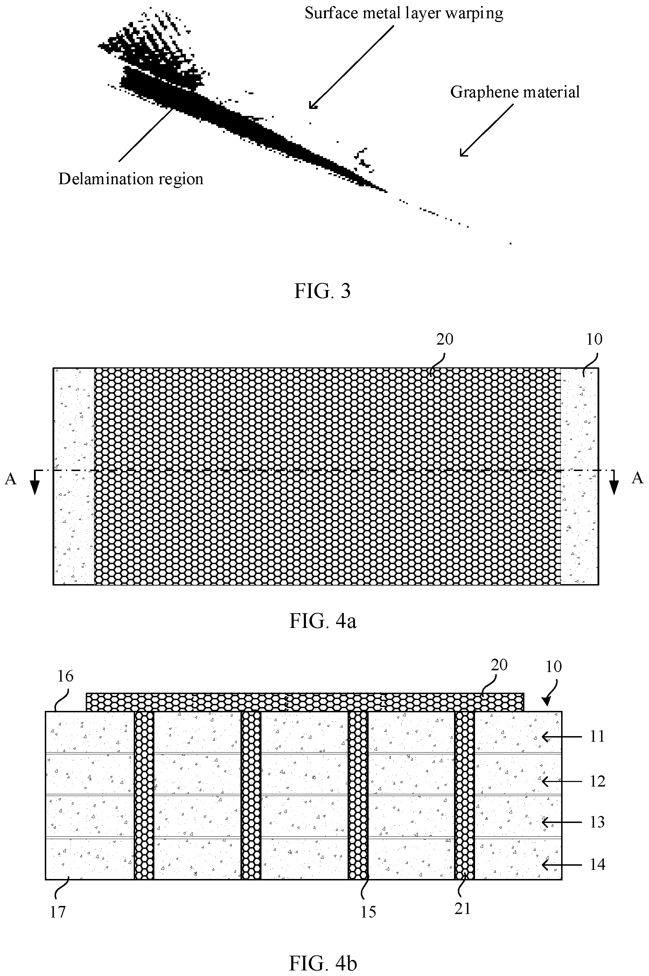

Refer to FIG. 3. FIG. 3 shows a schematic photo of a delaminated graphene sheet. As shown in FIG. 3, a metal layer is formed on a surface of the graphene sheet, and a delamination region is formed between a first graphene layer and a second graphene layer.

It can be learned from FIG. 2 and FIG. 3 that, in the metallization process of the graphene material, the graphene material is delaminated, and consequently an original structure of the graphene material is damaged, and overall heat conduction performance of the graphene is affected.

To resolve the foregoing technical problem, this application provides a graphene sheet. A structure of the graphene material is changed, so that in the metallization process of the graphene material, a problem of delamination between graphene layers is avoided, and heat dissipation performance of the graphene material is improved.

In embodiments of this application, the graphene sheet may be used in an electronic device, to dissipate heat for a heat emitting component in the electronic device, for example, dissipate heat for a component like a CPU.

The following describes a specific structure of the graphene sheet in embodiments of this application with reference to the accompanying drawings.

Refer to FIG. 4a and FIG. 4b. FIG. 4a is a top view of a graphene sheet according to an embodiment of this application, and FIG. 4b is a cross-sectional view in the A-A direction in FIG. 4a. As shown in FIG. 4a and FIG. 4b, the graphene sheet includes a substrate layer 10 and a metal layer 20. The substrate layer 10 includes a plurality of graphene layers disposed in a thickness direction of the substrate layer. An example in which the substrate layer includes four graphene layers: a graphene layer 11, a graphene layer 12, a graphene layer 13, and a graphene layer 14 is used for description. At least one hole 15 is provided in a preset region of the substrate layer 10. The preset region may be determined based on a position at which the graphene sheet is connected to another metal part. One or more holes 15 may be provided according to an actual requirement. The at least one hole 15 extends in the thickness direction of the substrate layer 10 from a first surface 16 (an upper surface shown in the figure) to a second surface 17 (a lower surface shown in the figure) opposite to the first surface, and an extension distance of the hole is less than or equal to a thickness.

As shown in FIG. 4a, the metal layer 20 is disposed on the first surface 16, and metal pillars 21 of the metal layer 20 extend through a plurality of holes 15 toward the second surface 17 of the substrate layer 10. A length of the metal pillar 21 may be less than or equal to a length of the hole, or the metal pillar may extend out of the hole. In this embodiment, an example in which the length of the metal pillar 21 is less than or equal to the length of the hole is used for description. A periphery of the metal pillar 21 abuts against a side wall of the hole. There may be an interaction friction force between the metal pillar 21 and the hole wall, or a chemical bond is formed between the metal pillar and the hole wall, so that "pinning" effect is achieved. In this way, the graphene layers can be effectively fastened, and a delamination problem of the graphene material caused by thermal stress is avoided.

In embodiments of this application, a plurality of holes 15 are provided in the substrate layer 10. A density of the holes 15 may be set according to an actual requirement. For example, to better protect integrity of the graphene sheet and better fasten the graphene layers, the density of the holes may be greater than 0.01/mm², for example, may be 0.02/mm², 0.03/mm², 0.05/mm², 0.1/mm², or 0.2/mm². In addition, these holes may be arranged in different arrangement manners. The following describes arrangement of the holes.

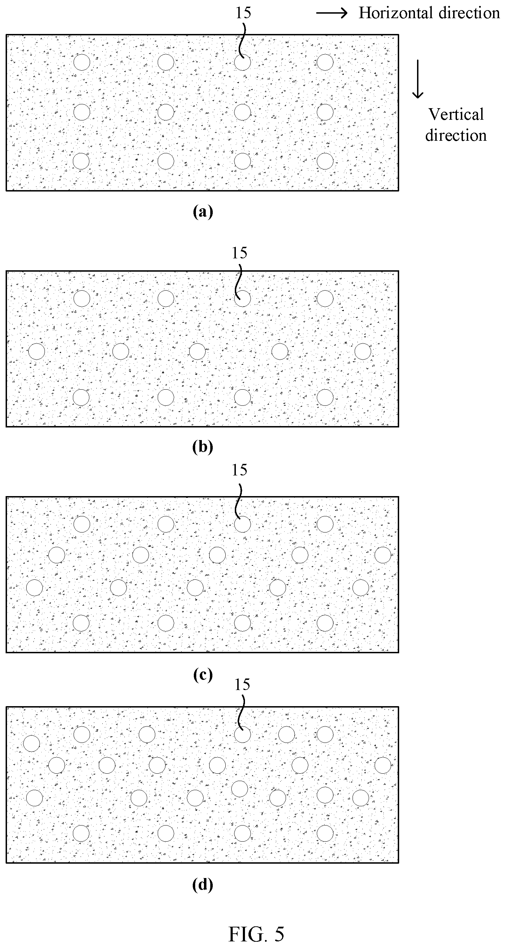

Refer to FIG. 5. FIG. 5 is a diagram of an arrangement structure of holes on a surface of graphene observed from a top-view perspective. As shown in (a) in FIG. 5, a plurality of holes 15 are arranged orderly in a horizontal direction and a vertical direction of the substrate layer. Spacings between horizontally arranged holes are the same, and spacings between vertically arranged holes are the same. This structure facilitates a more uniform fastening force for "pinning" between layers. In some embodiments of this application, holes may be arranged in a plurality of arrangement manners. As shown in (b) in FIG. 5, every two groups of horizontally arranged holes are staggered with a group of horizontally arranged holes between the two groups of horizontally arranged holes. Alternatively, as shown in (c) in FIG. 5, these holes are arranged in an obliquely aligned manner. These orderly arrangement manners help the graphene layer bear a uniform force. In some other embodiments, as shown in (d) in FIG. 5, these holes may alternatively be arranged irregularly. An arrangement manner of the holes is not specifically limited in this application.

In embodiments of this application, the hole may be a blind hole, or may be a through hole. A depth of the blind hole may be set according to a requirement.

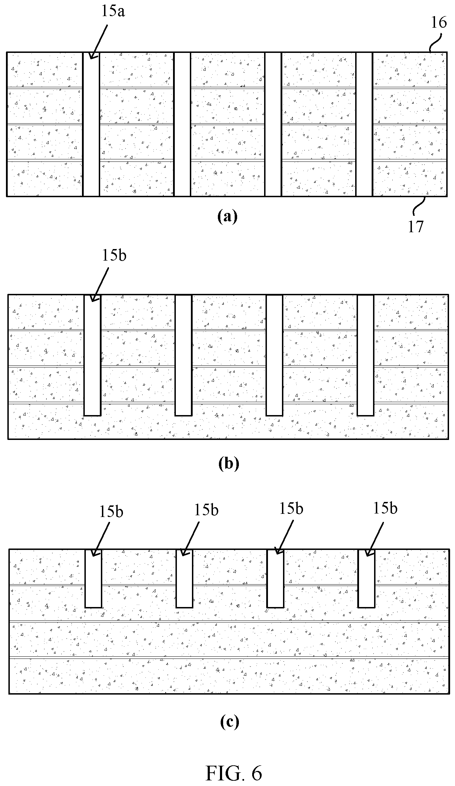

Refer to FIG. 6. FIG. 6 is a diagram of a structure of a hole in a graphene sheet according to an embodiment of this application. As shown in (a) in FIG. 6, the hole may be a through hole 15a that penetrates the first surface 16 and the second surface 17 of the substrate layer. Alternatively, the hole may be a blind hole 15b shown in (b) in FIG. 6 and (c) in FIG. 6. The blind hole 15b may pass through first three graphene layers and terminate at a fourth graphene layer, that is, does not pass through the fourth graphene layer, as shown in (b) in FIG. 6. Alternatively, as shown in (c) in FIG. 6, the blind hole passes through only a first graphene layer and terminates at a second graphene layer. In some embodiments of this application, the blind hole 15b may terminate at any intermediate graphene layer in the thickness direction of the substrate layer, or just between two graphene layers. In an actual processing process, the depth of the blind hole may be processed to facilitate processing and satisfaction of "pinning". This is not limited in this application.

In the foregoing embodiments, an example in which all holes are through holes or all holes are blind holes is used for description. In some other embodiments of this application, the structure may alternatively be a hybrid structure of a blind hole and a through hole.

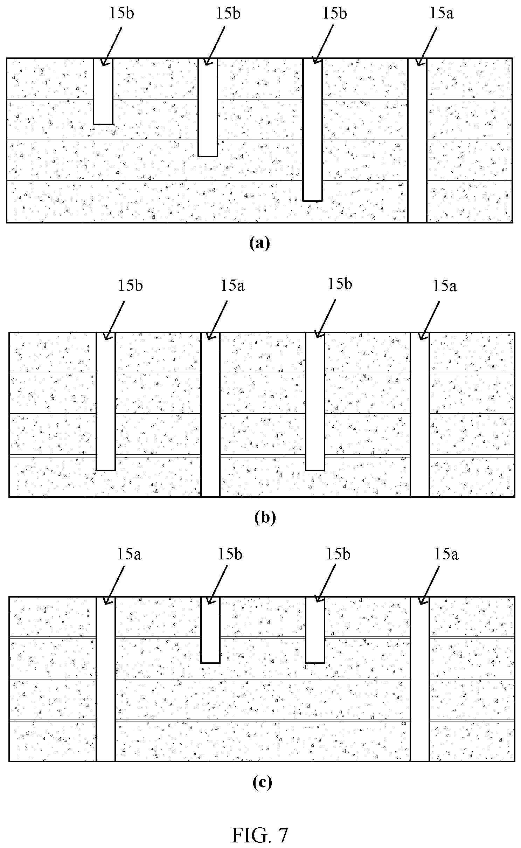

Refer to FIG. 7. FIG. 7 is a diagram of a hybrid structure of a blind hole and a through hole in a graphene sheet according to an embodiment of this application. As shown in (a) in FIG. 7, the blind hole 15b and the through hole 15a may be hybrid. Different depths may be set for blind holes 15b. For example, extension lengths of the blind holes 15b may be respectively: reaching the second graphene layer, reaching the third graphene layer, and reaching the fourth graphene layer. In addition, the holes may be arranged from left to right or from right to left in a shallow-to-deep manner based on the depths. Alternatively, as shown in (b) in FIG. 7, the holes may be alternately arranged based on the depths. Alternatively, as shown in (c) in FIG. 7, a depth of a hole at an edge of the preset region is greater than a depth of a hole close to the middle. That is, the hole at the edge is the through hole 15a, and the hole close to the middle is the blind hole 15b. In this way, delamination of the graphene layer at an outer edge can be better avoided. In this application, a hybrid manner of a blind hole and a through hole is used, which is more conducive to proper setting of depths of holes at different positions according to a requirement in an actual processing process, so that processing flexibility is improved.

In embodiments of this application, a shape of a cross section of the hole may be a circle, a square, a triangle, or the like, or may be another irregular shape. This is not limited in this application.

In some embodiments of this application, a hole size may be set according to an actual requirement. For example, when the thickness of the substrate layer is less than or equal to 2 mm, on the cross section of the hole, a distance between two points that are farthest from each other is less than 5 mm, for example, may be 4 mm, 3 mm, 2 mm, or 1 mm. **In** an embodiment of this application, on the cross section of the hole, the distance between the two points that are farthest from each other may be 0.1 mm to 0.2 mm. This size can better fasten the graphene layer, and avoid that an excessively large hole size greatly affects integrity of the graphene material. When the thickness of the graphene increases, the hole size may be increased accordingly.

In an embodiment of this application, to ensure that delamination does not occur at the graphene edge after metallization, it needs to be ensured that a shortest distance between an edge of the substrate layer and an edge of the hole is not greater than 5 mm, for example, may be 4 mm, 3 mm, 2 mm, or 1 mm. In some other embodiments, when a planar size of the substrate layer increases, the shortest distance may alternatively be greater than 5 mm, for example, may be 5.5 mm or 6 mm.

In the foregoing embodiments, the structure of the graphene sheet is described. The following describes a preparation method for a graphene sheet with the structure shown in FIG. 4 to FIG. 7.

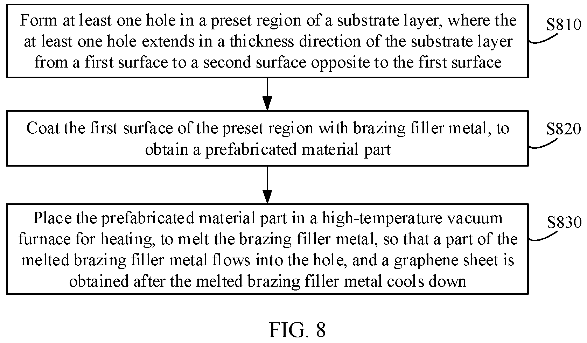

Refer to FIG. 8. FIG. 8 is a flowchart of a preparation method for a graphene sheet according to an embodiment of this application. As shown in FIG. 8, the method includes S810 to S830.

S810: Form at least one hole in a preset region of a substrate layer, where the at least one hole extends in a thickness direction of the substrate layer from a first surface to a second surface opposite to the first surface. An extension distance of the hole is less than or equal to a thickness of the substrate layer.

This step is as follows: Before graphene is metallized, the hole is processed, by using a technology such as a laser, a computer numerical control (Computer numerical control, CNC) machine, or a water jet, in a region (preset region) that needs to be metallized on the first surface of the substrate layer, and for example, may be a through hole or a blind hole.

For a depth of the hole, refer to the structure shown in FIG. 6 and FIG. 7 in the foregoing embodiments. For a hole arrangement manner, refer to the arrangement manner shown in FIG. 7. Details are not described herein again.

S820: Cover the first surface of the preset region with brazing filler metal, to obtain a prefabricated material part.

The brazing filler metal may include a titanium (Ti) element, and a percentage of atoms of titanium in a total quantity of atoms of the brazing filler metal may be less than or equal to 15%. In addition, the brazing filler metal may further include another element, for example, one or a combination of a plurality of elements such as copper (Cu), silver (Ag), tin (Sn), and nickel (Ni). The copper element has good wettability and strong reactivity for a metal layer, and is conducive to subsequent low-temperature brazing. The silver element can reduce a melting point of a raw material of the metal layer, reduce a peak temperature required in a metallization process of a graphene surface, and reduce a deformation or oxidation rate of the graphene in the high-temperature metallization process.

In some embodiments of this application, the first surface of the substrate layer may be further covered with a foil including the Ti element.

In an embodiment of this application, a thickness of the brazing filler metal may be less than or equal to 2.0 mm, for example, may be 1.5 mm, 1 mm, or 0.5 mm.

In an embodiment of this application, the brazing filler metal may be in a paste form or a sheet form. When the brazing filler metal is in the paste form, the surface of the preset region may be coated with brazing filler metal of a specific thickness. When the brazing filler metal is a sheet-like solid, the surface of the preset region may be patched with brazing filler metal of a specific thickness.

S830: Place the prefabricated material part in a high-temperature vacuum furnace for heating, to melt the brazing filler metal, so that a part of the melted brazing filler metal flows into the hole, and a graphene sheet is obtained after the melted brazing filler metal cools down.

A metal liquid flowing into the hole reacts with a graphene contact surface (hole wall), and Ti in the brazing filler metal forms a "Ti-C" chemical bond with the inner side wall of the graphene hole, to achieve effect similar to "pinning". After the melted brazing filler metal on the first surface is fully spread and reacted, the high-temperature vacuum furnace cools down to a normal temperature. In this process, thermal stress is generated at an interface between the solidified metal layer and the graphene. Graphene layers are fastened under the action of the "Ti-C" chemical bond, and a delamination problem of the graphene substrate layer caused by thermal stress is avoided.

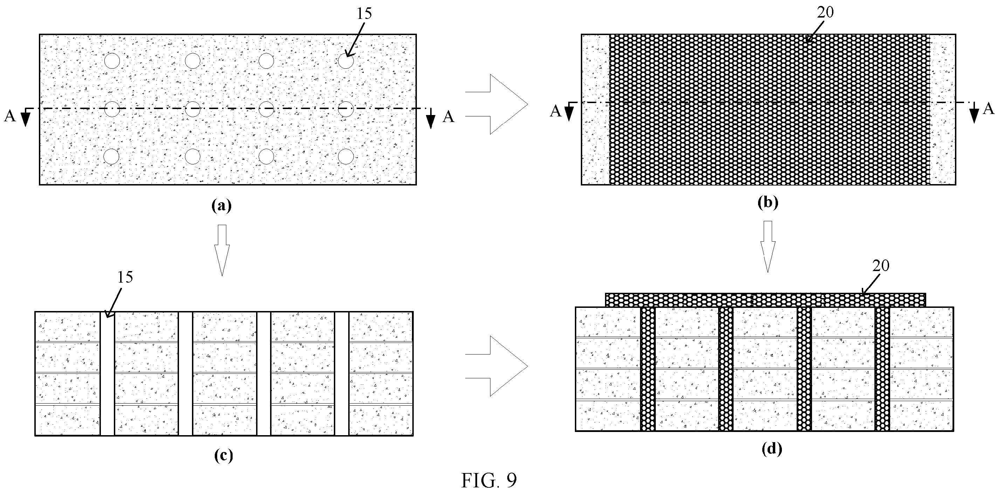

Refer to FIG. 9. FIG. 9 is a diagram of a structure in a graphene preparation process according to an embodiment of this application. (a) and (b) in FIG. 9 are top views, and (c) and (d) in FIG. 9 are cross-sectional views. (c) in FIG. 9 is a cross-sectional view along A-A corresponding to (a) in FIG. 9, and (d) in FIG. 9 is a cross-sectional view along A-A corresponding to (b) in FIG. 9. When the graphene sheet is prepared, puncturing is performed on the substrate layer, to obtain the diagrams of the structures shown in (a) and (c) in FIG. 9. The first surface is coated with the brazing filler metal or the foil, and the brazing filler metal or the foil is melted at a high temperature. After the preset region is filled with the brazing filler metal or the foil, a part of a metal solution flows into the hole and cools down to a room temperature, to obtain the diagrams of the structures shown in (b) and (d) in FIG. 9.

In the graphene sheet preparation process in the foregoing embodiment, a micropore structure is designed in the graphene sheet before high-temperature metallization. After infiltration of the brazing filler metal, the structure can change a direction of thermal stress generated by a metal layer and graphene due to a thermal expansion coefficient, and the brazing filler metal and an inner side wall of the hole form a chemical bond and physical bonding effect, to resist an exfoliation force of the graphene layer in a metallization process, and resolve a problem of surface delamination after high-temperature metallization of graphene.

In FIG. 4 to FIG. 9 above, an example in which the described metal layer on the surface of the substrate layer is a continuous metal layer is used for description. In another embodiment of this application, to reduce thermal stress generated in the graphene metallization process, the preset region may be divided into a metal region and a non-metal region, and the metal layer is disposed in the metal region, to form a discontinuous form of the metal layer.

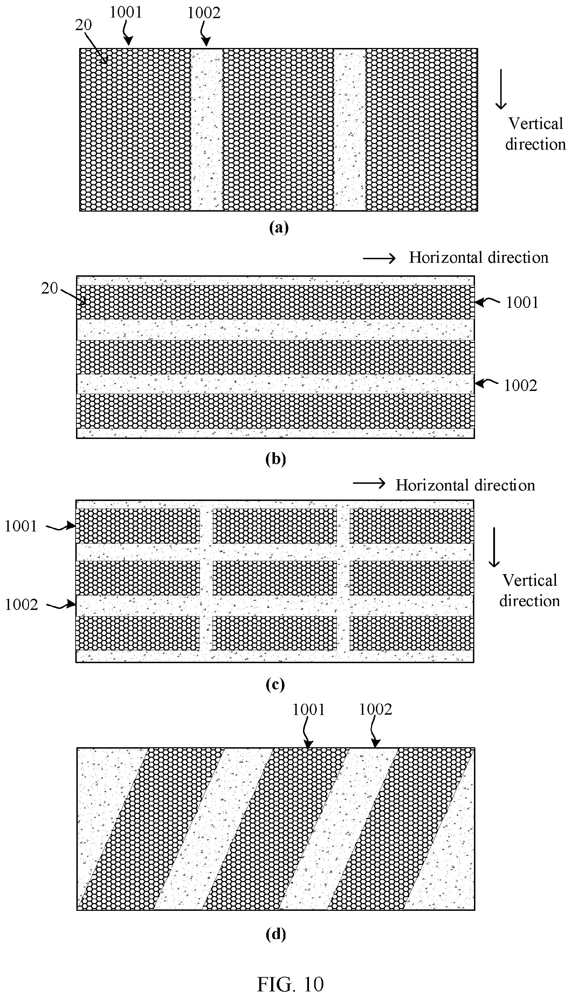

Refer to FIG. 10. FIG. 10 is a diagram of a structure of a graphene sheet divided into regions in different directions of a substrate layer according to an embodiment of this application. In a process of division into a metal region 1001 and a non-metal region 1002, division may be performed in a vertical direction of the substrate layer, or division may be performed in a horizontal direction of the substrate layer. As shown in (a) in FIG. 10, from a top-view perspective, three metal regions 1001 and two non-metal regions 1002 are obtained through division in the vertical direction of the substrate layer. As shown in (b) in FIG. 10, from a top-view perspective, three metal regions 1001 and two non-metal regions 1002 are obtained through division in the horizontal direction of the substrate layer. As shown in (c) in FIG. 10, from a top-view perspective, nine metal regions 1001 and four non-metal regions 1002 are obtained through division in the horizontal direction and the vertical direction of the substrate layer. As shown in (d) in FIG. 10, from a top-view perspective, the metal region 1001 and the non-metal region 1002 are obtained through division in a direction of an oblique line intersecting the bottom of the substrate layer. This structure reduces a surface area of each metal layer 20, so that thermal stress inside the metal layer 20 is reduced when the brazing filler metal is melted at a high temperature and then cools down. Further, a problem of delamination of graphene layers is avoided, and a problem of warping caused when the metal layer greatly deforms due to the thermal stress can be avoided. In an actual processing process, a quantity of metal regions, a division direction, and the like may be determined according to a requirement. This is not limited in this application.

After the substrate layer is divided into a plurality of metal regions, a position of a corresponding hole may be provided in the metal region. A hole arrangement manner in each metal region may be the same as the arrangement manner shown in FIG. 5.

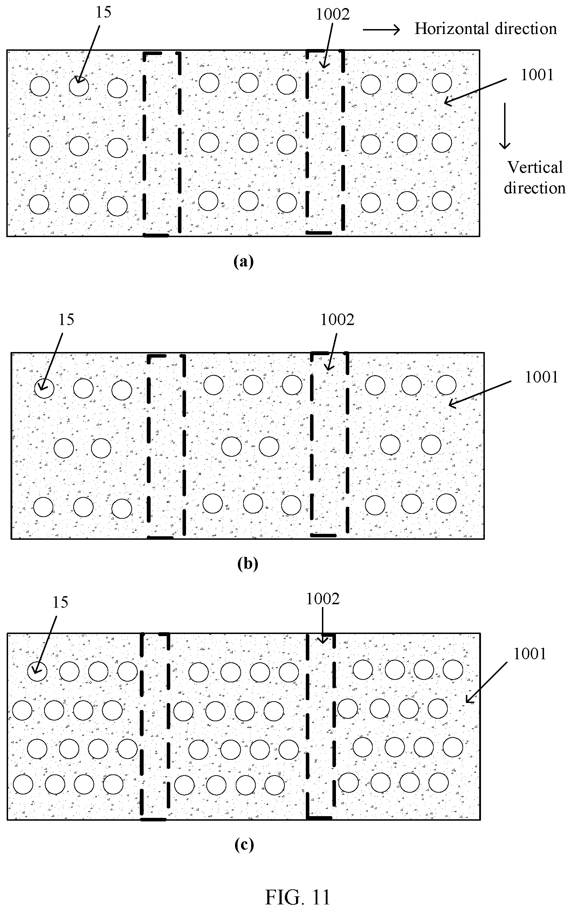

Refer to FIG. 11. FIG. 11 is a diagram of a structure of arranging a hole in a metal region of a substrate layer according to an embodiment of this application. As shown in (a) in FIG. 11, a metal region 1001 and a non-metal region 1002 are disposed on a surface of the substrate layer. Holes 15 are provided in the metal region 1001, and the plurality of holes 15 are arranged orderly in a horizontal direction and a vertical direction of the metal region. In another embodiment, another arrangement manner may alternatively be used. As shown in (b) and (c) in FIG. 11, a plurality of holes are on the metal region 1001, and every two adjacent horizontally arranged holes 15 are staggered with each other. Quantities of holes 15 in all rows may be the same or may be different. As shown in (b) in FIG. 11, a quantity of holes 15 in a second row is less than that in a first row and a third row. As shown in (c) in FIG. 11, quantities of holes 15 in all rows are the same. These orderly arrangement manners better help the graphene layers bear a uniform force after a pinning force is formed. In some embodiments, the holes may alternatively be arranged in an unordered manner. This is uniquely limited in this application.

In addition, in some embodiments, a division line between the metal region and the non-metal region may be a curve, an arc, or the like.

In FIG. 10 and FIG. 11 above, the structure of the graphene sheet divided into regions is described. The following describes a preparation method for a graphene sheet with the structure shown in FIG. 10 and FIG. 11.

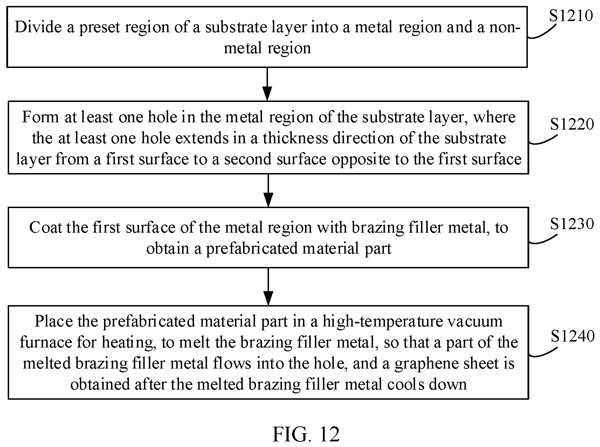

Refer to FIG. 12. FIG. 12 is a flowchart of a preparation method for a graphene sheet according to another embodiment of this application. As shown in FIG. 12, the method includes S1210 to S1240.

S1210: Divide a preset region of a substrate layer into a metal region and a non-metal region. For a division manner of the metal region and the non-metal region, refer to the division manner shown in FIG. 10. Details are not described herein again.

S1220: Form at least one hole in the metal region of the substrate layer, where the at least one hole extends in a thickness direction of the substrate layer from a first surface to a second surface opposite to the first surface.

For a puncturing manner in the metal region, refer to S810 in FIG. 8. A manner of providing a hole in the preset region is the same. For details, refer to the description in S810.

S1230: Cover the first surface of the metal region with brazing filler metal, to obtain a prefabricated material part. In this step, an area of the metal region is different from that of the preset region. For another preparation process, refer to the description in S820.

S1240: Place the prefabricated material part in a high-temperature vacuum furnace for heating, to melt the brazing filler metal, so that a part of the melted brazing filler metal flows into the hole, and a graphene sheet is obtained after the melted brazing filler metal cools down. This step corresponds to S830. For details, refer to the description in S830.

The following separately performs a warping simulation test on the graphene sheets prepared by using the preparation methods shown in FIG. 8 and FIG. 12.

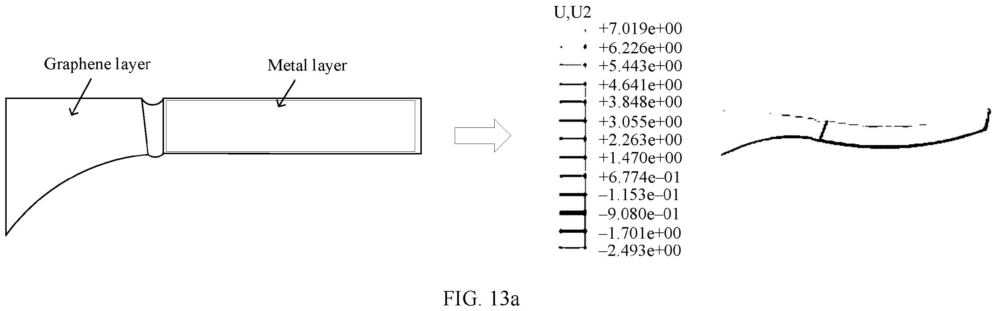

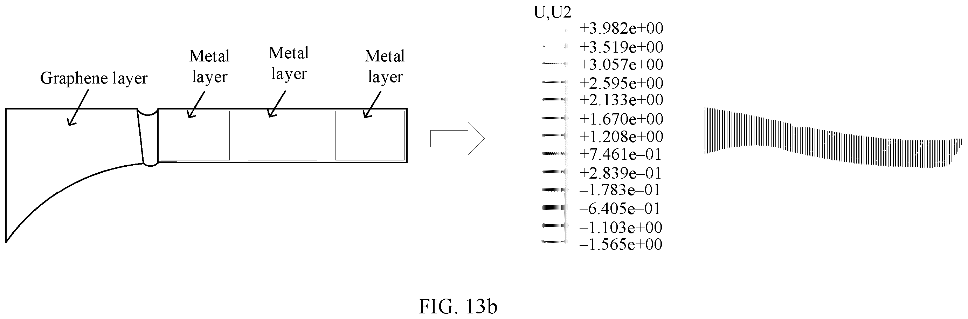

Refer to FIG. 13a. FIG. 13a is a diagram of a simulation test of a warping degree of a graphene sheet that is not divided into regions according to an embodiment of this application. As shown in FIG. 13, a metal layer of a graphene sheet on the left side of the figure is not divided into regions, a simulation test is performed on the entire metal layer, and a test result on the right side of the figure and a structural diagram that expresses a warping degree are obtained. A measured warping degree range of the graphene sheet with the structure is -2.493e+00 to +7.019e+00. A maximum warping degree is +7.019e+00. The warping degree is greatly reduced compared with that of an existing non-punctured graphene sheet.

Refer to FIG. 13b. FIG. 13b is a diagram of a simulation test of a warping degree of a graphene sheet that is divided into regions according to an embodiment of this application. As shown in FIG. 13b, a metal layer of a graphene sheet on the left side of the figure is divided into three regions. A simulation test is performed on the graphene sheet with the structure, and a test result on the right of the figure and a structural diagram that expresses a warping degree are obtained. A warping degree range of the graphene sheet on which the simulation test is performed is -1.565e+00 to +3.982e+00, and a maximum warping degree is +3.982e+00. It can be learned that, compared with that of the structure of the graphene sheet shown in FIG. 13a, the warping degree is significantly reduced, and the maximum warping degree is reduced by about 43.1%. The reduction of the warping degree can effectively reduce delamination of graphene layers.

According to the graphene sheet divided into regions in this embodiment of this application, a horizontal, vertical, or hybrid segment-based metallization layout solution is used to help disperse thermal stress and improve warping deformation of the graphene sheet caused by thermal stress concentration. The region-divided metallization solution reduces warping deformation of the metal region of the graphene.

The graphene sheet in this application may be used in an electronic device. For example, the graphene sheet may be used as a heat dissipation module in the electronic device.

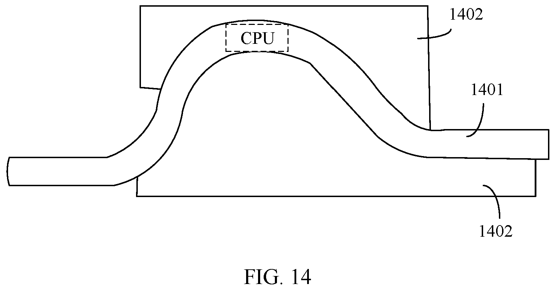

This application further discloses a heat dissipation module. Refer to FIG. 14. FIG. 14 is a diagram of a structure of a heat dissipation module according to an embodiment of this application. As shown in FIG. 14, the heat dissipation module includes a heat dissipation part 1401 and a graphene sheet 1402. The heat dissipation part 1401 includes a metal housing and a liquid medium located in the metal housing, for example, a heat pipe.

As shown in FIG. 14, the graphene sheet may be divided into two pieces, and the heat dissipation part 1401 is disposed between the two pieces of graphene sheets 1402. At least a part of a metal layer of the graphene sheet 1402 is welded to the heat dissipation part 1401. The heat dissipation part 1401 is in contact with a heat source component that emits heat, for example, a CPU. The heat dissipation part 1401 uses the liquid working medium located in a sealed cavity formed by the metal housing to absorb and evaporate heat, and then implement heat transfer and heat dissipation through a continuous cycle process of condensation and heat release. The heat is transferred to the graphene sheet 1402 in contact with the heat dissipation part. The graphene sheet 1402 further transfers the heat to another heat dissipation component, for example, a dense-tooth heat sink or a fin. In this way, a quick heat dissipation function of the heat dissipation module is implemented. Because the graphene sheet is relatively light, the entire heat dissipation module is relatively light. Not only a lightweight requirement can be met, but also there is relatively good heat conduction effect. In addition, heat transfer efficiency is not affected due to problems such as delamination or warping of the graphene sheet.

In addition, this application further discloses an electronic device. The electronic device includes the heat dissipation module shown in FIG. 14. In addition, the electronic device is light, and heat generated by an internal heat emitting point can be quickly conducted by the heat dissipation module, so that generation of an internal heat emitting point of the electronic device is avoided, and user experience and safety and stability of the electronic device are improved.

This application further discloses another electronic device. The electronic device includes the graphene sheet described in the foregoing embodiments. For a specific structure and a preparation method for the graphene sheet, refer to the description of the foregoing embodiments. Details are not described herein again. The electronic device has relatively good heat conduction performance, and heat generated inside the electronic device can be quickly conducted, so that generation of an internal heat emitting point of the electronic device is avoided, and user experience and safety and stability of the electronic device are improved. In some embodiments of this application, the electronic device may be an electronic device such as a notebook computer, a tablet computer, or a desktop computer, or may be an intelligent wearable device such as a watch or a band. A type of the electronic device is not limited in this application.

It should be noted that, for a ratio of raw materials and a preparation process that are not mentioned above, refer to the conventional technology. Details are not described herein again.

It should be understood that sequence numbers of the foregoing processes do not mean execution sequences in various embodiments of this application. Some or all of the steps may be performed in parallel or in sequence. The execution sequences of the processes should be determined based on functions and internal logic of the processes, and should not be construed as any limitation on the implementation processes of embodiments of this application.

Although this application has been illustrated and described with reference to some preferred embodiments of this application, a person of ordinary skill in the art should understand that various changes may be made to this application in form and detail without departing from the spirit and scope of this application.

## Claims

1. A graphene sheet, comprising:
a substrate layer, wherein the substrate layer comprises a plurality of graphene layers disposed in a thickness direction of the substrate layer, at least one hole is provided in a preset region of the substrate layer, the at least one hole extends in the thickness direction of the substrate layer from a first surface to a second surface opposite to the first surface, and an extension distance of the hole is less than or equal to the thickness; and
a metal layer, wherein the metal layer is disposed on the first surface, a metal pillar of the metal layer extends through the hole toward the second surface of the substrate layer, and at least a part of a periphery of the metal pillar is in contact with a side wall of the hole.

2. The graphene sheet according to claim 1, wherein there are a plurality of holes, and extension lengths of the plurality of holes are not equal.

3. The graphene sheet according to claim 2, wherein an extension length of a hole close to an edge of the substrate layer is greater than an extension length of a hole away from the edge of the substrate layer.

4. The graphene sheet according to claim 1, wherein extension lengths of a plurality of holes are equal.

5. The graphene sheet according to any one of claims 1 to 4, wherein a chemical bond is formed between the metal pillar in the hole and the hole wall.

6. The graphene sheet according to any one of claims 1 to 5, wherein a density of a quantity of holes arranged in the preset region is greater than 0.01/mm².

7. The graphene sheet according to claim 6, wherein the horizontally arranged holes and the vertically arranged holes are aligned or staggered.

8. The graphene sheet according to any one of claims 1 to 7, wherein the thickness of the substrate layer is less than or equal to 2 mm, and a distance between two points that are farthest from each other on a cross section of the hole is less than 5 mm.

9. The graphene sheet according to any one of claims 1 to 8, wherein a distance between the hole and an outer edge of the substrate layer is less than or equal to 5 mm.

10. The graphene sheet according to claim 1, wherein brazing filler metal corresponding to the metal layer comprises titanium and one or more elements of copper, silver, tin, and nickel.

11. The graphene sheet according to claim 1, wherein the first surface of the preset region of the substrate layer is divided into a metal region and a non-metal region, one non-metal region is provided between every two adjacent metal regions, and the metal layer is disposed in the metal region.

12. The graphene sheet according to any one of claims 1 to 11, wherein the hole is a through hole or a blind hole.

13. The graphene sheet according to any one of claims 1 to 12, wherein the cross section of the hole is a circle, a triangle, or a square.

14. A preparation method for a graphene sheet, wherein the graphene sheet comprises a substrate layer, the substrate layer comprises a plurality of graphene layers disposed in a thickness direction of the substrate layer, and the method comprises:
forming at least one hole in a preset region of the substrate layer, wherein the at least one hole extends in the thickness direction of the substrate layer from a first surface to a second surface opposite to the first surface, and an extension distance of the hole is less than or equal to the thickness;
covering the first surface of the preset region with brazing filler metal, to obtain a prefabricated material part; and
placing the prefabricated material part in a high-temperature vacuum furnace for heating, to melt the brazing filler metal, so that a part of the melted brazing filler metal flows into the hole, and the graphene sheet is obtained after the melted brazing filler metal cools down.

15. The preparation method according to claim 14, wherein there are a plurality of holes, and extension lengths of the plurality of holes are not equal.

16. The preparation method according to claim 14, wherein the forming at least one hole in a preset region of the substrate layer comprises:
arranging the holes in a horizontal direction and a vertical direction of the preset region in an aligned or staggered arrangement manner, or arranging the holes in an obliquely aligned manner.

17. The preparation method according to any one of claims 14 to 16, wherein the first surface of the preset region comprises a metal region and a non-metal region, and the forming at least one hole in a preset region of the substrate layer comprises:
dividing the preset region into the metal region and the non-metal region, wherein the metal region and the non-metal region are spaced apart; and
forming at least one hole in the metal region of the preset region; and
the covering the first surface of the preset region with brazing filler metal comprises:
covering the metal region with the brazing filler metal.

18. The preparation method according to any one of claims 14 to 17, wherein a thickness of the brazing filler metal covering the surface of the preset region is less than or equal to 2.0 mm.

19. A heat dissipation module, comprising:
a heat dissipation part, wherein the heat dissipation part comprises a metal housing; and
a graphene sheet, wherein a metal layer on a surface of the graphene sheet is connected to the housing of the heat dissipation part, and the graphene sheet is the graphene sheet according to any one of claims 1 to 13.

20. The heat dissipation module according to claim 19, wherein the heat dissipation part is a heat pipe.

21. An electronic device, comprising the heat dissipation module according to claim 19 or 20.
